Europäisches Patentamt

**European Patent Office**

**Office européen des brevets**

(11) Numéro de publication: **0 483 009 B1**

(12) **FASCICULE DE BREVET EUROPEEN**

(45) Date de publication de fascicule du brevet: **18.01.95**

(51) Int. Cl.6: **C04B 41/87**, C04B 35/52, C04B 35/80, C23C 16/32

(21) Numéro de dépôt: **91402845.1**

(22) Date de dépôt: **24.10.91**

(54) **Procédé d'élaboration d'un matériau composite réfractaire protégé contre la corrosion.**

(30) Priorité: **26.10.90 FR 9013323**

(43) Date de publication de la demande:
**29.04.92 Bulletin 92/18**

(45) Mention de la délivrance du brevet:
**18.01.95 Bulletin 95/03**

(84) Etats contractants désignés:
**DE FR GB IT**

(56) Documents cités:
**EP-A- 0 121 797**
**US-A- 4 889 686**
**US-A- 4 894 286**
**US-A- 4 944 904**

(73) Titulaire: **SOCIETE EUROPEENNE DE PROPUL-SION**
**24, rue Salomon de Rothschild**
**F-92150 Suresnes (FR)**

(72) Inventeur: **Goujard, Stéphane**
**11, allée Paul Doumer**
**F-33700 Mérignac (FR)**
Inventeur: **Vandenbulcke, Lionel**
**131bis, rue Demay**
**F-45650 Saint Jean le Blanc (FR)**
Inventeur: **Rey, Jacques**
**2, rue de la Vallère**
**F-33700 Mérignac (FR)**
Inventeur: **Charvet, Jean-Luc**
**54 rue J.-B. Clément**
**Hastignan,**
**F.33160 St. Médard en Jalles (FR)**
Inventeur: **Tawil, Henri**
**Nouveau Longchamp,**
**34, avenue Léon Blum**
**F-33110 Le Bouscat (FR)**

(74) Mandataire: **Joly, Jean-Jacques et al**
**Cabinet Beau de Loménie**
**158, rue de l'Université**
**F-75340 Paris Cédex 07 (FR)**

Rank Xerox (UK) Business Services
(3.10/3.09/3.3.3)

## Description

La présente invention concerne la protection des matériaux composites réfractaires contre la corrosion, plus particulièrement contre l'action de l'oxygène et éventuellement de l'eau à température élevée.

Les matériaux composites visés par l'invention sont les matériaux comprenant un renfort fibreux réfractaire densifié par une matrice également réfractaire.

Le matériau constitutif des fibres du renfort fibreux est généralement le carbone, ou une céramique telle que le carbure de silicium, par exemple. La matrice réfractaire est formée par du carbone, ou au moins partiellement par une céramique telle que, par exemple, du carbure de silicium ou un oxyde réfractaire. Une interphase, notamment en pyrocarbone ou nitrure de bore, peut être formée sur les fibres du renfort pour assurer une liaison adéquate entre le renfort fibreux et la matrice.

La densification du renfort fibreux par la matrice est réalisée par voie liquide ou par voie gazeuse, la densification visant à combler au moins partiellement la porosité accessible du renfort fibreux, dans tout le volume de celui-ci.

Dans le premier cas, le renfort fibreux est imprégné par un précurseur de la matrice, par exemple une résine. L'imprégnation est suivie par un traitement thermique par lequel le matériau constitutif de la matrice est obtenu par transformation du précurseur. Plusieurs cycles successifs imprégnation-traitement thermique peuvent être réalisés.

Dans le deuxième cas, le renfort fibreux est placé dans une enceinte dans laquelle est admise une phase gazeuse qui se décompose ou réagit dans des conditions particulières de température et de pression pour former un dépôt sur les fibres du renfort, dans tout le volume de celui-ci. Des procédés d'infiltration chimique en phase vapeur de matériaux réfractaires, notamment de matériaux céramiques, éventuellement après formation d'une interphase de liaison fibres-matrice, sont bien connus. On pourra se référer aux documents FR-A-2 401 888, EP-A-0 085 601 et EP-A-0 172 082.

Les matériaux composites réfractaires sont remarquables par leurs propriétés thermostructurales, c'est-à-dire des propriétés mécaniques qui les rendent aptes à constituer des éléments de structure, et par la capacité de conserver ces propriétés mécaniques jusqu'à des températures élevées. Ces matériaux trouvent donc des applications en particulier dans les domaines aéronautique et spatial.

Toutefois, les matériaux composites réfractaires placés en atmosphère agressive lors de leur utilisation sont susceptibles d'être dégradés par la corrosion s'attaquant aux fibres du renfort, à l'interphase fibres-matrice ou à la matrice.

Une corrosion qui pose en pratique des problèmes particulièrement aigus est l'action de l'oxygène ou l'action combinée de l'oxygène et de l'eau, qui se manifeste lorsque les renforts fibreux ou matrices des matériaux contiennent des phases oxydables (telles que carbone, nitrure de bore, ...) et sont placés à température élevée en présence d'air, de gaz de combustion, d'humidité, de pluie, ... C'est ce qui se produit par exemple pour des matériaux constitutifs de chambre de combustion de turboréacteur, ou de parties externes de véhicules spatiaux lors de la rentrée dans l'atmosphère.

L'action des agents corrosifs est favorisée par la fissuration pratiquement inévitable des matériaux composites réfractaires. En effet, lors de l'utilisation de ces matériaux, des fissures, généralement des micro-fissures, apparaissent par suite de contraintes mécaniques appliquées aux matériaux ou en raison d'une différence entre les coefficients de dilatation thermique du renfort fibreux et de la matrice.

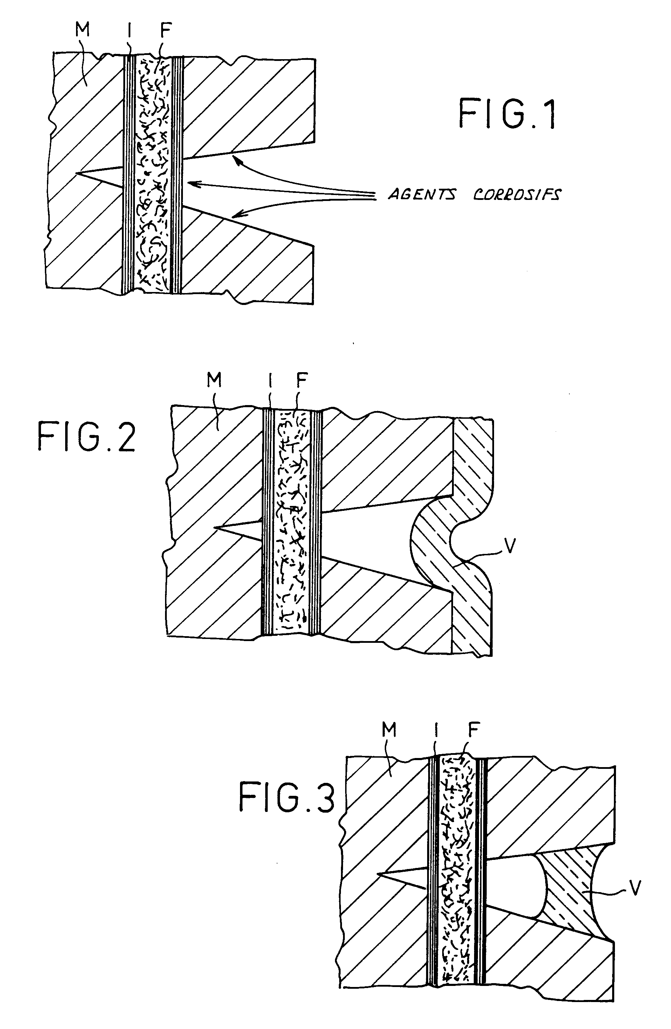

Comme l'illustre très schématiquement la figure 1 annexée, chaque fissure donne aux agents corrosifs accès non seulement au matériau de la matrice M, mais aussi aux fibres F éventuellement gainées par une interphase I. En raison de la porosité résiduelle quasi-inévitable du matériau (la densification du renfort fibreux est rarement complète), ce phénomène se produit non seulement en surface, mais aussi au coeur du matériau, les agents corrosifs cheminant par la porosité.

Pour des applications à température élevée au contact de l'air et éventuellement en présence d'humidité, il est donc nécessaire de protéger les matériaux composites réfractaires.

Il existe un état de la technique très abondant à propos de la protection des matériaux composites réfractaires, en particulier de la protection anti-oxydation des matériaux composites contenant du carbone. Les techniques utilisées font souvent appel à la formation d'une protection ayant des propriétés cicatrisantes pour colmater, remplir ou étancher les fissures apparaissant dans le matériau. Au cours de l'utilisation du matériau, les variations des contraintes mécaniques et thermiques se traduisent par des variations de la géométrie des fissures, notamment par rapprochement ou écartement de leurs lèvres. Il est donc nécessaire que le matériau de protection cicatrisant puisse suivre ces mouvements sans lui-même se fissurer. C'est pourquoi la protection est habituellement constituée d'éléments qui constituent un verre ou qui sont susceptibles de constituer un verre, par exemple après oxydation, le verre présentant un comportement visqueux à la température d'utilisation du matériau.

EP 0 483 009 B1

Comme le montrent les figures 2 et 3, le verre V assure une fonction de protection en formant une barrière contre l'accès des agents corrosifs aux fissures du matériau. Dans le cas de la figure 2, le verre V est formé à partir d'éléments déposés sur le matériau composite. Dans le cas de la figure 3, le verre V est formé à partir d'éléments contenus dans des phases de la matrice, par corrosion (oxydation) de ces éléments.

Il est connu de réaliser une protection anti-oxydation de matériaux composites réfractaires par dépôt d'une couche constituée d'un composé du silicium et/ou dépôt d'une couche constituée d'un composé du bore, pour aboutir à la formation du verre à base d'oxyde de bore ($B_2O_3$) ou à base de silice ($SiO_2$) ou une combinaison des deux. A titre d'illustration de cet état de la technique, il peut être fait référence aux documents US-A-4 668 579 et EP-0 176 055.

Dans le document US-A-4 668 579 (invention Strangman et al), la protection anti-oxydation d'un matériau composite C/C est réalisée en formant au moins une couche de protection comprenant une partie interne de carbure de bore et une partie externe de carbure de silicium. De préférence, la couche de protection est formée avant densification complète du matériau composite, typiquement après l'étape de consolidation du renfort fibreux, c'est-à-dire après qu'une densification partielle ait été réalisée qui soit juste suffisante pour lier entre elles les fibres du renfort. L'épaisseur de chaque partie de la couche de protection est comprise entre 0,5 et 5 microns.

Dans le document EP-A-0 176 055 (invention Holzl et al), la protection anti-oxydation d'un corps en carbone (qui peut être en composite C/C) est réalisée en procédant d'abord à une attaque chimique du corps en carbone par un oxyde de bore pour former des interstices' qui s'étendent jusqu'à une profondeur déterminée et occupent la moitié environ du volume initial du corps en carbone jusqu'à cette profondeur. La porosité ainsi créée est comblée par introduction de silicium ou d'un alliage de silicium donnant, par réaction, une couche formée de borure de silicium et de carbure de silicium à parts sensiblement égales. Un revêtement de surface supplémentaire, par exemple en carbure de silicium, est formé avec ou sans couche intermédiaire de bore ou d'un composé du bore. Le corps de carbone ainsi traité montre une très bonne tenue à l'oxydation dans l'air à une température d'environ 1 370°C.

Les brevets US 4 889 686 et US 4 944 904 visent aussi l'élaboration d'un matériau composite protégé contre l'oxydation par introduction d'une composition contenant du silicium fondu au sein d'une préforme poreuse. La préforme est réalisée à partir de fibres revêtues de nitrure de bore, pour éviter le contact direct avec te silicium fondu, et revêtues éventuellement ensuite de carbone pyrolytique pour favoriser le mouillage par te silicium. Les fibres ainsi revêtues sont imprégnées par un promoteur d'infiltration sous forme de fibres courtes de carbone ou de whiskers de SiC et/ou de poudre de carbone mélangés à un liant tel qu'une résine. Après réalisation de la préforme poreuse par mise en forme des fibres imprégnées et traitement thermique, une infiltration liquide est réalisée au moyen d'un mélange de silicium et de bore à l'état fondu, la quantité de bore dans ce mélange représentant de préférence 1 à 3 % en poids par rapport au silicium. Le matériau composite obtenu comprend une matrice avec une phase principale constituée par du carbure de silicium formé in situ, ou du carbure de silicium contenant du bore et formé in situ, et une phase additionnelle constituée par une solution de silicium et de bore.

Parmi les verres susceptibles d'être formés par suite de la mise en oeuvre d'une protection anti-oxydation, ceux à base de bore ont une tenue limitée à basse pression et sont sensibles à l'effet d'humidité. Il n'en est pas de même pour les verres à base de silice, mais ceux-ci ne sont pas efficaces à moyenne température (leur température de transition est élevée).

Des verres mixtes à base de bore et de silice ou verres borosilicatés ne présentent plus ces défauts, ou du moins ces défauts sont très atténués. La juxtaposition de couches de précurseurs des verres à base de bore et à base de silice, par exemple une couche interne de carbure de bore ($B_4C$) et une couche externe de carbure de silicium (SiC) comme dans l'état de la technique évoqué plus haut, pourra donner naissance à un verre borosilicaté.

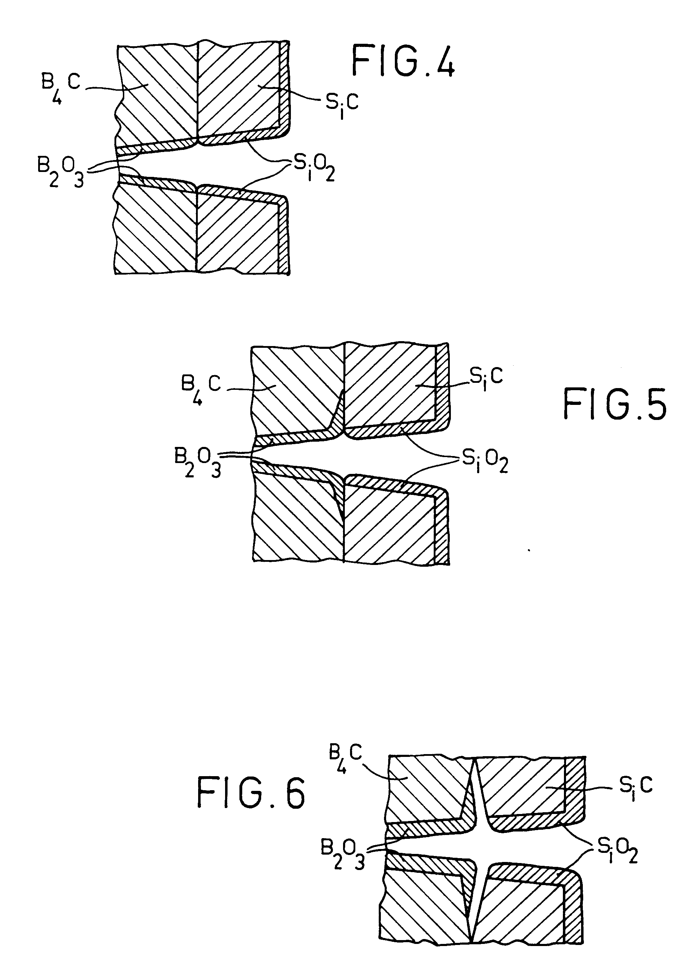

Comme le montre la figure 4 de façon très schématique, lorsque deux couches de $B_4C$ et SiC sont superposées, il se forme sur la paroi d'une fissure, dans des conditions oxydantes, des oxydes correspondants ($B_2O_3$ et $SiO_2$, respectivement) au niveau des couches de $B_4C$ et SiC. Ces oxydes sont générés de façon adjacente, le long de la fissure. Il n'y a pas formation immédiate de verre de type borosilicate. Aussi, à un stade initial de l'oxydation, on retrouve de façon juxtaposée les défauts précités des verres à base de bore et à base de silice. De plus, les couches de $B_4C$ et de SiC ne s'oxydent pas avec la même cinétique et n'ont pas les mêmes propriétés physico-chimiques, en particulier pas les mêmes coefficients de dilatation.

Aussi, en atmosphère oxydante à haute température, on observe une avancée de l'oxyde $B_2O_3$ à L'interface entre les couches $B_4C$ et SiC, comme le montre la figure 5. Si le matériau composite est alors placé en présence d'humidité, l'oxyde $B_2O_3$ s'hydrate en $B_2O_3$, n-$H_2O$ dont le volume est supérieur à celui

3

de l'oxyde qui lui a donné naissance. Ceci met en traction L'interface entre $B_4C$ et SiC, perpendiculairement aux couches, provoquant une désolidarisation entre ces couches (figure 6). Au pire, il y a écaillage de la couche externe SiC, mais il y a au moins fissuration à l'interface entre $B_4C$ et SiC et répétition du phénomène. Ces problèmes rencontrés avec des protections associant des couches $B_4C$ et SiC sont notamment décrits dans un article de C.W. OHLHORST et al. intitulé "Performance Evaluations of Oxidation-Resistant Carbon-Carbon Composites" (Fifth National Aero-Space Plane Symposium, October 18-21, 1988, Paper Number 69).

Aussi, la présente invention a-t-elle pour but de fournir un procédé permettant d'obtenir un matériau composite réfractaire protégé contre la corrosion dans une plage étendue de température, et jusqu'à au moins 1700°C, par formation d'au moins une couche cicatrisante d'un verre borosilicaté lorsque le matériau fissuré est placé en condition oxydante à température élevée.

Ce but est atteint du fait que, conformément à l'invention, le procédé comprend la formation, au sein de la matrice ou à la surface de celle-ci d'au moins une phase continue constituée par un système ternaire silicium-bore-carbone (Si-B-C), et obtenue par infiltration chimique ou dépôt chimique en phase vapeur à partir d'une phase gazeuse comprenant un mélange de précurseurs des éléments silicium, bore et carbone, de manière à obtenir une proportion de bore, dans le système ternaire Si-B-C, au moins égale à 5 % en pourcentage atomique. Par phase continue, on entend ici une couche qui constitue une barrière continue entre la surface externe du matériau et les fibres de son renfort fibreux.

La technique d'infiltration ou de dépôt chimique en phase vapeur est particulièrement avantageuse du fait qu'elle permet une répartition uniforme des éléments déposés formant la phase Si-B-C, en particulier un mélange intime et une répartition uniforme des éléments Si et B précurseurs du verre borosilicaté. Dans tout le texte, "phase Si-B-C" désignera donc un matériau ternaire Si-B-C où la répartition des éléments Si, B et C est uniforme. Ainsi, une oxydation de cette phase à température élevée conduit directement à la formation d'un verre borosilicaté, ce qui évite les inconvénients rencontrés dans le cas des couches superposées de précurseurs de verre à base de bore et de verre à base de silice.

La phase Si-B-C peut constituer la phase externe de la matrice, formant ainsi une protection de surface.

Avantageusement toutefois, la phase Si-B-C est formée au sein de la matrice pour constituer une protection intégrée quine risque pas d'être mise en échec par une destruction locale, comme ce pourrait être le cas avec une protection de surface.

Il est même possible de former la matrice essentiellement par la phase Si-B-C, celle-ci étant éventuellement séparée des fibres du renfort par une sous-couche et revêtue d'une protection supplémentaire en surface.

Lorsque le matériau composite contient du carbone, en tant que constituant des fibres du renfort ou d'une interphase entre les fibres et la matrice, il est avantageux de séparer le carbone de la phase Si-B-C par une phase réfractaire ne contenant pas de bore, par exemple une phase en un carbure réfractaire tel que le carbure de silicium, de zirconium ou de hafnium. L'incorporation d'une telle phase réfractaire permet d'éviter au carbone de réagir avec le verre formé par la phase Si-B-C, et au bore de diffuser dans le carbone.

Enfin, le matériau composite pourra être muni, en fin d'élaboration, d'un revêtement de surface en carbure réfractaire, par exemple en carbure de silicium, ou en oxyde, constituant une barrière supplémentaire contre l'oxygène.

Un autre avantage du procédé selon l'invention tient à ce que, notamment par la sélection des proportions relatives des constituants de la phase gazeuse, il est possible de commander précisément les proportions des éléments du système ternaire Si-B-C. De la sorte, la composition du système ternaire Si-B-C peut être ajustée précisément pour permettre la formation d'un verre borosilicaté adapté à la température d'utilisation envisagée pour le matériau composite, c'est-à-dire d'un verre qui présente, à cette température, les propriétés de viscosité nécessaires pour assurer de façon optimale une fonction cicatrisante vis-à-vis des fissures dans la matrice du matériau.

Il existe certes dans l'état de la technique des matériaux composites dans lesquels la matrice comporte les éléments Si, B et C. Ainsi, dans les brevets précités US 4 889 686 et US 4 944 904, la matrice comprend une phase SiC, éventuellement SiC contenant B et une phase Si + B. Toutefois, et contrairement au procédé conforme à l'invention, la technique décrite dans ces brevets, à savoir infiltration de carbone élémentaire suivie d'imprégnation liquide par un mélange de silicium et bore fondus, ne permet pas d'obtenir'un mélange intime des éléments Si, B et C dans une même phase, avec une répartition régulière de ces éléments dans cette phase, et ne permet pas de contrôler précisément les proportions relatives des éléments Si, B et C dans cette même phase, avec une variation possible de la proportion de bore dans une large plage, par exemple de 5 % jusqu'à 60 % en pourcentage atomique de bore. Or, ces deux conditions : mélange intime et répartition uniforme des éléments Si, B, C dans une même phase, et contrôle précis de leurs proportions sont nécessaires à l'obtention, dans les meilleures conditions possibles, du verre borosilicaté souhaité.

De plus, et contrairement à la technique d'imprégnation liquide, le dépôt chimique ou l'infiltration chimique en phase vapeur utilisés conformément à l'invention permettent de contrôler précisément l'épaisseur de la phase Si-B-C, ainsi que la localisation de celle-ci dans la matrice.

Un autre avantage spécifique du procédé selon l'invention réside dans la possibilité de réaliser le système ternaire Si-B-C de façon continue avec d'autres phases de la matrice, lorsque celles-ci sont également formées par infiltration chimique ou dépôt chimique en phase vapeur. Il suffit alors en effet, pour passer de la phase Si-B-C à une autre phase (ou réciproquement), de modifier la composition de la phase gazeuse et, le cas échéant, certains paramètres tels que température et pression.

En particulier, pour passer d'une phase SiC à une phase Si-B-C, ou inversement, il suffit de modifier la composition de la phase gazeuse par augmentation ou diminution de la proportion du précurseur de l'élément bore. Cette modification peut être réalisée de façon progresive pour aboutir à une transition continue entre les phases SiC et Si-B-C.

Des exemples de mise en oeuvre du procédé selon l'invention seront maintenant décrits à titre indicatif, mais non limitatif.

Sur les dessins annexés,

- les figures 1 à 6, déjà décrites, illustrent les phénomènes de fissuration et d'oxydation de matériaux composites réfractaires,
- la figure 7 illustre très schématiquement une installation permettant l'élaboration d'un matériau composite réfractaire protégé conformément à l'invention,
- les figures 8 et 9 illustrent la variation de la composition d'un système ternaire Si-B-C obtenu par infiltration ou dépôt chimique en phase vapeur en fonction de la composition de la phase gazeuse utilisée, respectivement à 927°C et à 1027°C,
- la figure 10 est une microphotographie montrant un matériau composite réfractaire protégé conforme à l'invention avec phase Si-B-C intégrée,
- la figure 11 est une microphotographie montrant un matériau composite réfractaire de type SiC/SiC avec phase Si-B-C intégrée,
- la figure 12 montre des courbes illustrant l'analyse élémentaire par microsonde de Castaing du matériau de la figure 11 pour mesurer les variations des teneurs en oxygène, carbone, silicium et bore,
- la figure 13 est une microphotographie montrant un matériau composite réfractaire à renfort en fibres SiC et à matrice séquencée comprenant trois phases Si-B-C séparées par des couches SiC,
- les figures 14 à 16 illustrent l'effet de la présence d'une phase Si-B-C pour la protection contre la corrosion d'un matériau composite réfractaire protégé conforme à l'invention,
- la figure 17 est une microphotographie montrant le colmatage d'une fissure par un verre de type borosilicate dans un matériau composite protégé conformément à l'invention,
- les figures 18 et 19 sont des microphotographies montrant respectivement un fragment d'un matériau tel que celui de la figure 13 dans lequel un trou a été formé, et, avec un plus fort grossissement, une partie de la paroi du trou, après traitement thermique sous air, et
- la figure 20 montre des courbes illustrant la variation de la perte de masse en fonction de la durée de traitement d'oxydation à 1300°C pour des pièces en matériau composite 2D C/SiC revêtues d'une couche Si-B-C.

Dans les exemples donnés plus loin, les matériaux composites réfractaires à protéger sont généralement de type bidimensionnel (2D), ou tridimensionnel (3D) en carbone/carbone (C/C) ou en carbone/carbure de silicium (C/SiC, texture fibreuse de renfort densifiée par une matrice essentiellement en carbure de silicium). Bien entendu, l'invention est tout aussi applicable à d'autres matériaux composites réfractaires 2D ou 3D, par exemple des matériaux composites 2D carbure de silicium/carbure de silicium (SiC/SiC) avec interphase pyrocarbone ou nitrure de bore entre les fibres SiC du renfort et la matrice SiC.

Un matériau composite 2D est un matériau dans lequel les fibres du renfort fibreux forment un sytème bidimensionnel constitué par un tissu ou des nappes de fils ou de câbles éventuellement en quelques couches superposées.

Un matériau composite 3D est un matériau dans lequel les fibres du renfort forment un système tridimensionnel. La texture de renfort est par exemple obtenue par tissage tridimensionnel ou par superposition et liaison entre elles de strates bibimensionnelles de tissus, feutres, nappes de fils ou de câbles, ..., les liaisons entre strates étant réalisées par aiguilletage, implantation de fils, ...

Le matériau composite est muni d'au moins une phase continue de protection à coeur et/ou en surface par un processus d'infiltration et/ou dépôt chimique en phase vapeur. A cet effet, une installation telle que celle décrite dans le document FR 2 594 119 peut être utilisée.

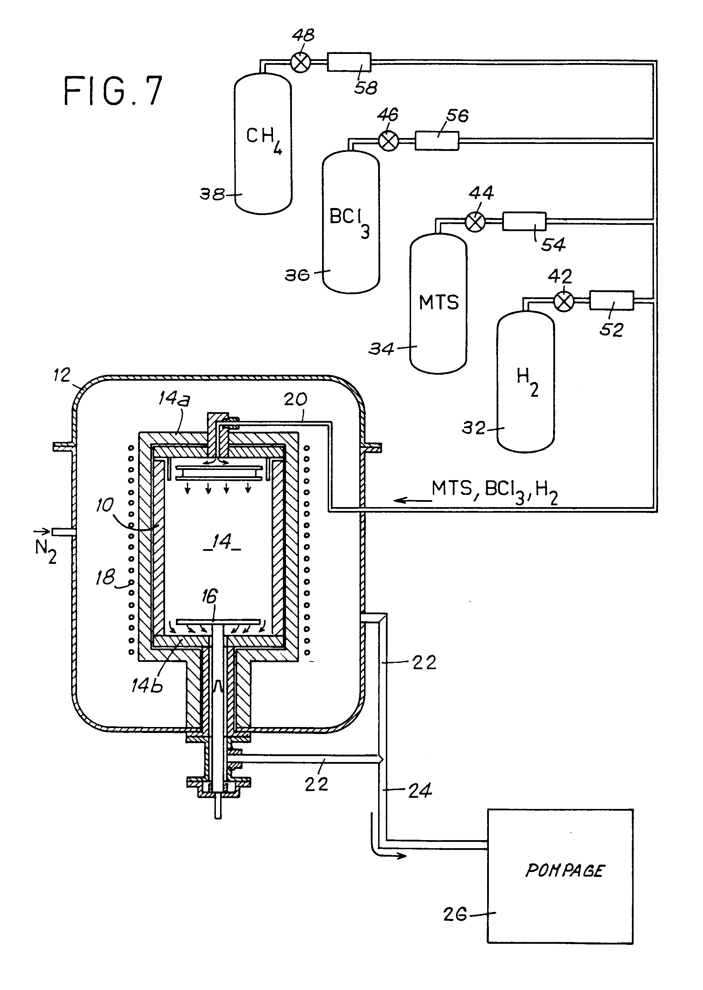

Cette installation (figure 7) comprend un suscepteur en graphite 10 situé à l'intérieur d'une enceinte 12 et délimitant une chambre de réaction 14 dans laquelle les pièces en matériau composite à traiter sont disposées sur un plateau tournant 16. Le chauffage du suscepteur est assuré par un inducteur 18 disposé autour de celui-ci.

L'alimentation de la chambre de réaction 14 par la phase gazeuse donnant le dépôt voulu est réalisée par une canalisation 20 qui traverse la paroi de l'enceinte 12 et aboutit dans la chambre 14 à travers un couvercle 14a fermant celle-ci à sa partie supérieure.

L'extraction des gaz résiduels hors de la chambre de réaction est réalisée au moyen d'une ou plusieurs conduites 22 qui s'ouvrent dans le fond 14b de la chambre et se raccordent, à l'extérieur de l'enceinte, à une canalisation 24 reliée à un dispositif de pompage 26.

Le volume situé autour du suscepteur 10, à l'intérieur de l'enceinte 12, est balayé par un gaz neutre, tel que de l'azote $N_2$ formant tampon autour de la chambre de réaction.

Des sources de gaz 32, 34, 36, 38 fournissent les constituants de la phase gazeuse introduite dans la chambre de réaction. Chaque source est reliée à la canalisation 20 par une conduite comprenant une vanne d'arrêt à commande automatique, respectivement 42, 44, 46, 48 et un débitmètre massique, respectivement 52, 54, 56, 58, les débitmètres permettant de réguler les proportions relatives des constituants de la phase gazeuse.

Pour le dépôt de système ternaire Si-B-C, la phase gazeuse est constituée d'un mélange de précurseurs des éléments Si, B et C auxquels est ajouté un élément réducteur tel l'hydrogène $H_2$.

Les éléments carbone et silicium peuvent être générés par des précurseurs appartenant respectivement aux familles des hydrocarbures et des silanes ou chlorosilanes. Ils peuvent être également générés conjointement par décomposition de précurseur organo-silicié, tel le méthyltrichlorosilane (MTS).

L'élément B est généré par un borane ou un halogénure, tel le trichlorure de bore ($BCl_3$).

Les sources de gaz 32, 34, 36 sont par conséquent respectivement des sources d'$H_2$, de MTS et de $BCl_3$.

La source de gaz 38 est une source d'hydrocarbure, par exemple de méthane, permettant d'engendrer l'élément carbone, ce qui permet d'utiliser l'installation pour former la matrice du matériau composite, lorsque cette matrice est au moins en partie en carbone, ou pour former une interphase pyrocarbone entre les fibres de renfort du matériau composite et une matrice céramique. Dans ce dernier cas, lorsque la matrice céramique est un carbure de silicium, celle-ci peut être formée, après l'interphase pyrocarbone, en remplaçant la phase gazeuse constituée de méthane par une phase gazeuse formée par un mélange de MTS et d'hydrogène.

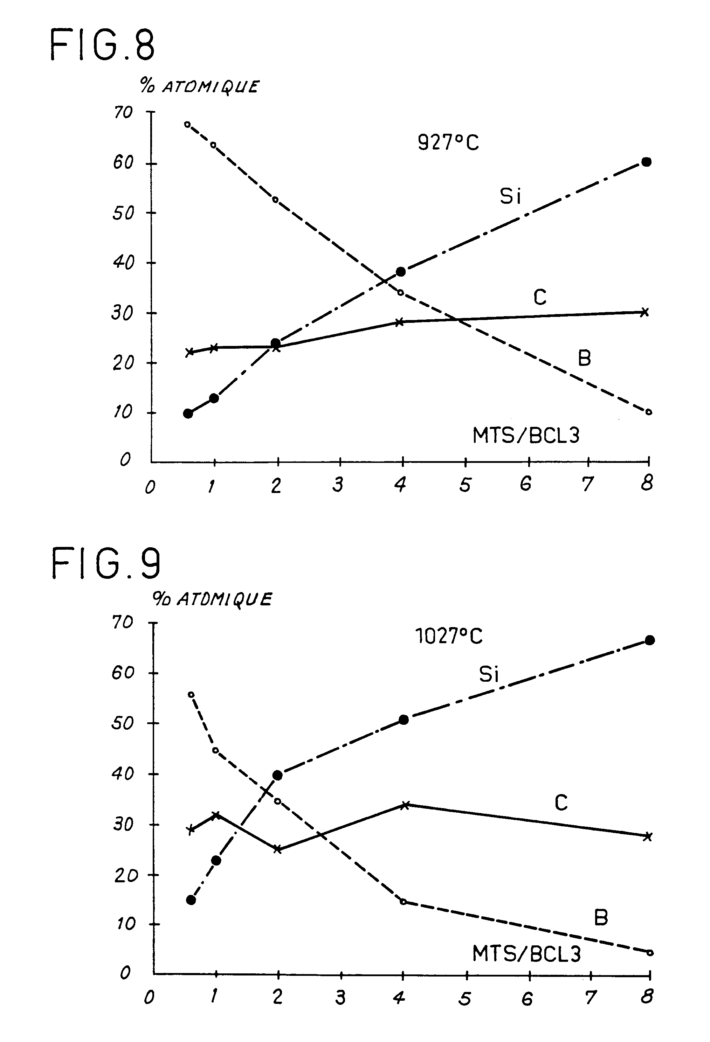

La composition du système ternaire Si-B-C est notamment fonction de la proportion, dans la phase gazeuse, des précurseurs MTS et $BCl_3$. Pour un rapport donné entre débit massique de $H_2$ et débit massique de MTS, la figure 8 illustre la variation de la composition du système ternaire Si-B-C (en pourcentage atomique de chaque élément) en fonction du rapport entre le débit massique de MTS et le débit massique de $BCl_3$, et pour une température de 927°C à l'intérieur de la chambre de réaction. La figure 9 montre la même variation pour une température de 1027°C à l'intérieur de la chambre de réaction.

Ainsi, il est possible de commander relativement précisément la composition du système ternaire Si-B-C par sélection des proportions relatives de MTS et $BCl_3$ dans la phase gazeuse. En fonction de la température d'utilisation du matériau composite, il est donc possible d'adapter la composition du système ternaire Si-B-C à l'obtention d'un verre de type borosilicate ayant le comportement voulu à cette température.

En outre, il est extrêmement facile de passer d'une phase de matrice SiC à une phase Si-B-C, ou inversement. Il suffit d'introduire, ou de supprimer, le précurseur $BCl_3$ dans la phase gazeuse constituée par ailleurs de MTS et $H_2$.

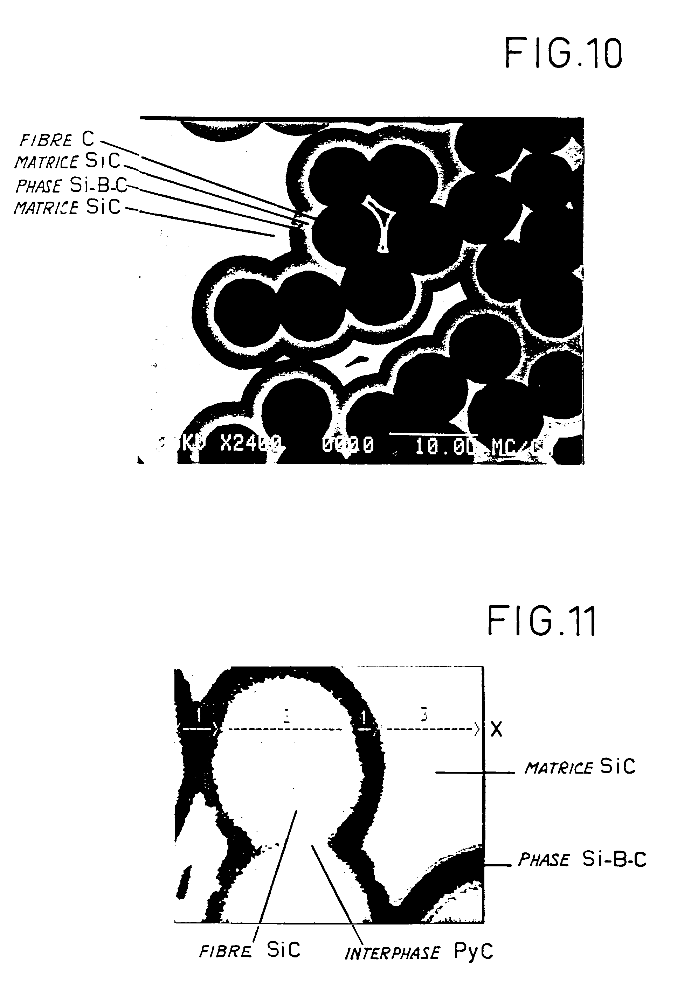

Cette modification de la composition de la phase gazeuse peut être progressive, ce qui permet une transition continue entre les phases SiC et Si-B-C, ou instantanée. Sur la figure 10, on voit un matériau composite C/SiC dans lequel est intégrée une phase continue Si-B-C. La matrice comprend une première phase interne SiC entre les fibres carbone et la phase Si-B-C et une phase externe SiC formée sur la phase Si-B-C. La transition entre la première phase SiC et la phase Si-B-C est progressive, donnant un gradient de composition entre ces deux phases. Par contre, la phase externe SiC présente une interface abrupte avec la phase Si-B-C.

L'infiltration chimique en phase vapeur de la phase Si-B-C au sein du matériau composite, à partir d'une phase gazeuse contenant un mélange de MTS, $BCl_3$ et $H_2$, est réalisée à une température comprise entre 800°C et 1150°C et sous une pression comprise entre $0,1.10^3$ et $50.10^3$ N/m². Bien entendu, un dépôt externe d'une phase Si-B-C peut être réalisé dans des conditions analogues.

La figure 11 montre un matériau composite de type SiC/SiC avec interphase pyrocarbone (PyC) entre les fibres SiC du renfort fibreux et la matrice. Celle-ci comprend une phase intégrée Si-B-C qui est formée sur l'interphase PyC par infiltration chimique en phase vapeur, le reste de la matrice étant constitué par du SiC déposé par infiltration chimique en phase vapeur dans la continuité de la phase Si-B-C, avec transition continue par diminution progressive de la proportion du bore déposé.

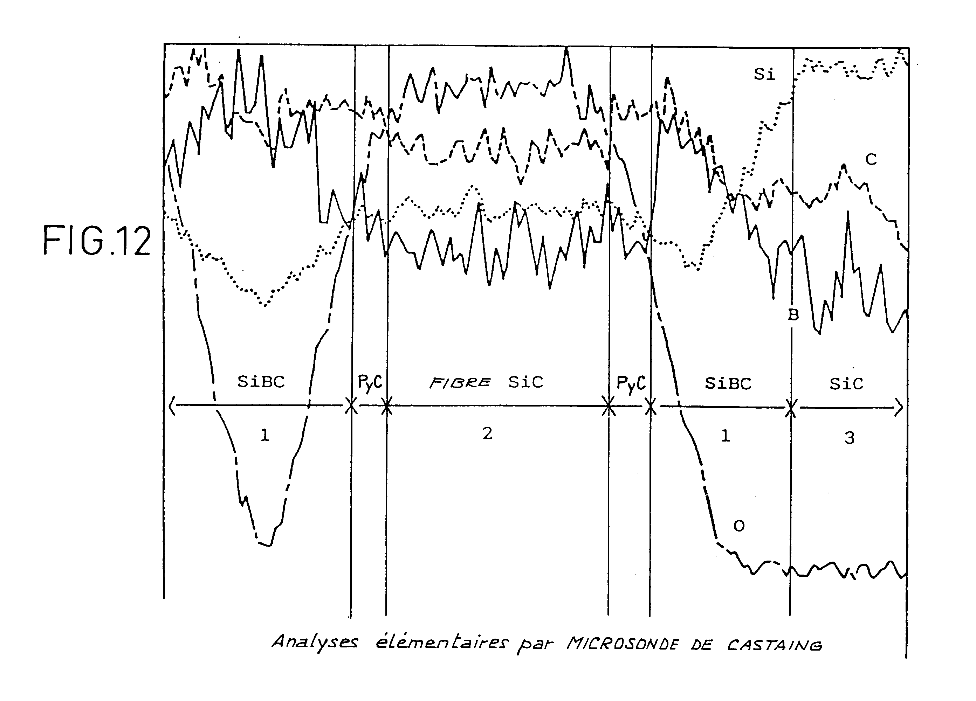

La figure 12 illustre le résultat de L'analyse du matériau par microsonde de Castaing suivant l'axe X de la figure 11. Au cours de cette analyse, les teneurs en oxygène (0), carbone (C), siLicium (Si) et bore (B) sont évaluées.

La courbe représentant la teneur en oxygène forme un plateau au niveau de la fibre, ce qui s'explique du fait que les fibres utilisées sont des fibres commercialisées sous l'appellation "Nicalon" par la société japonaise Nippon Carbon, lesquelles contiennent de l'oxygène en quantité notable. Par contre, l'oxygène est absent dans le reste du matériau.

La teneur en carbone forme un plateau au niveau de la fibre, puis croît naturellement au niveau de l'interphase PyC, ce que montre la courbe représentant la teneur en C. Cette courbe ne forme pas un plateau au niveau de l'interphase PyC en raison de la résolution insuffisante de la sonde, celle-ci formant un spot dont le diamètre est plus grand que l'épaisseur de la couche PyC (respectivement environ 1 micron et 0,5 micron). La teneur en carbone décroît ensuite jusqu'à une valeur sensiblement constante dans les couches Si-B-C et SiC.

La courbe représentant la teneur en silicium forme un plateau au niveau de la fibre avant de décroître dans l'interphase PyC pour croître à nouveau au niveau de la phase Si-B-C. Ensuite, cette courbe forme un plateau dans la phase restante SiC de la matrice.

La courbe représentant la teneur en bore forme un plateau au niveau de la fibre et de l'interphase PyC et croît brusquement au début de la phase Si-B-C. On observe ensuite une décroissance de la teneur en bore qui illustre bien la transition progressive entre les phases Si-B-C et SiC.

La figure 12 montre donc qu'il est possible de passer de la phase Si-B-C à la phase SiC sans interrompre le processus d'infiltration chimique en phase vapeur, simplement par modification de la composition de la phase gazeuse. Le passage inverse d'une phase SiC à une phase Si-B-C est tout aussi possible.

Le matériau de la figure 11 a été réalisé et analysé essentiellement pour vérifier cette possibilité de transition progressive entre couche Si-B-C et couche SiC. Comme déjà indiqué, il est en effet préférable de ne pas déposer la phase Si-B-C directement au contact du carbone, comme c'est le cas dans ce matériau puisque la couche Si-B-C est au contact de l'interphase PyC.

Le procédé d'infiltration en phase vapeur permet non seulement de contrôler la composition de la phase Si-B-C et de passer facilement d'une phase Si-B-C à une phase SiC, mais aussi de contrôler l'épaisseur et la localisation de la phase Si-B-C dans la matrice. Il est en particulier possible de réaliser un matériau composite avec une matrice séquencée, c'est-à-dire comprenant plusieurs phases Si-B-C séparées les unes des autres par une phase différente, par exemple une phase SiC.

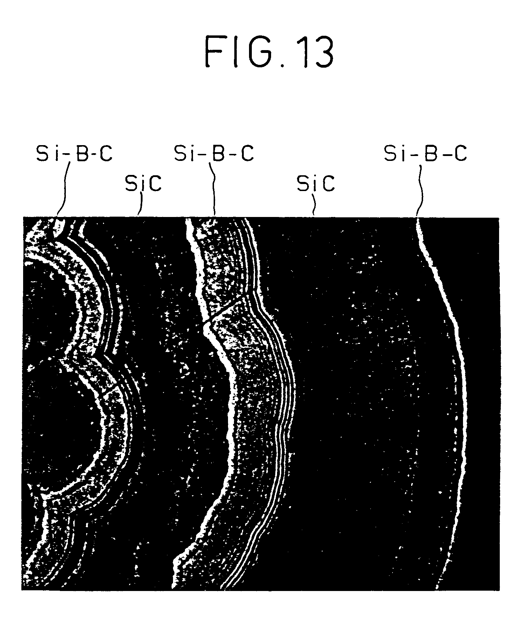

La figure 13 montre un tel matériau à matrice séquencée avec trois phases Si-B-C apparaissant en plus clair. Dans ce matériau, les fibres SiC sont revêtues d'une couche de PyC (apparaissant en plus sombre) séparée de la première phase SiB-C par une couche de SiC. Les trois phases Si-B-C sont séparées par des couches SiC et une phase externe SiC est formée sur la dernière phase Si-B-C.

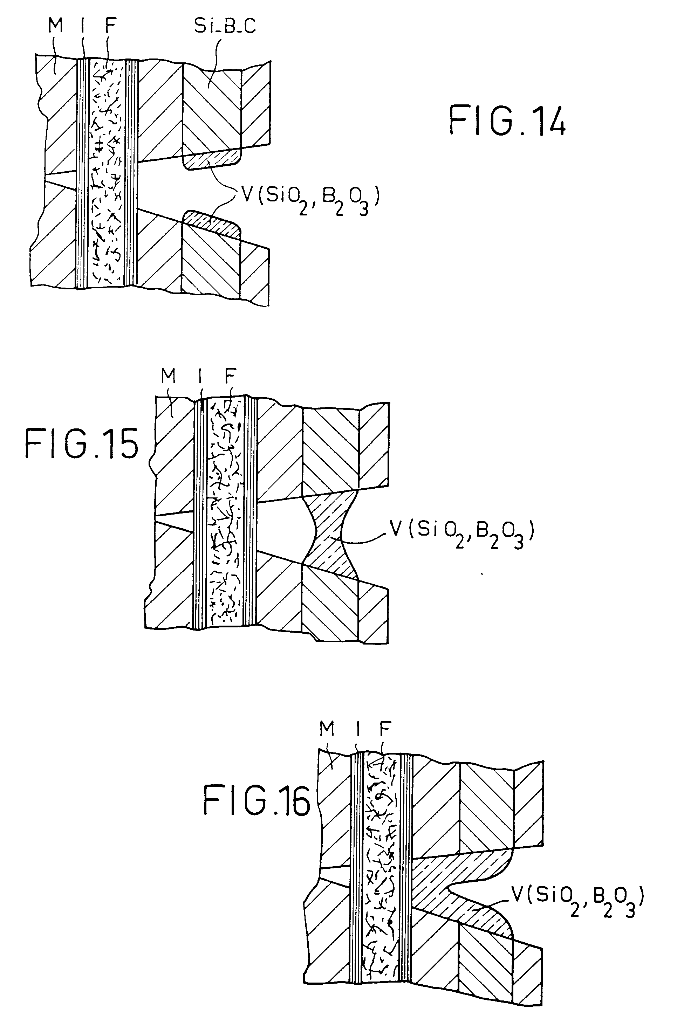

Les figures 14 à 16 montrent très schématiquement l'effet de la présence d'une phase Si-B-C intégrée dans un composite, une interphase I étant formée entre fibres F et matrice M.

En cas d'oxydation, un complexe ($SiO_2$, $B_2O_3$) est formé sur la paroi d'une fissure, au niveau de la phase Si-B-C (figure 14). Il se forme alors un verre V borosilicaté qui ferme la fissure (figure 15) et vient gainer la fibre (figure 16).

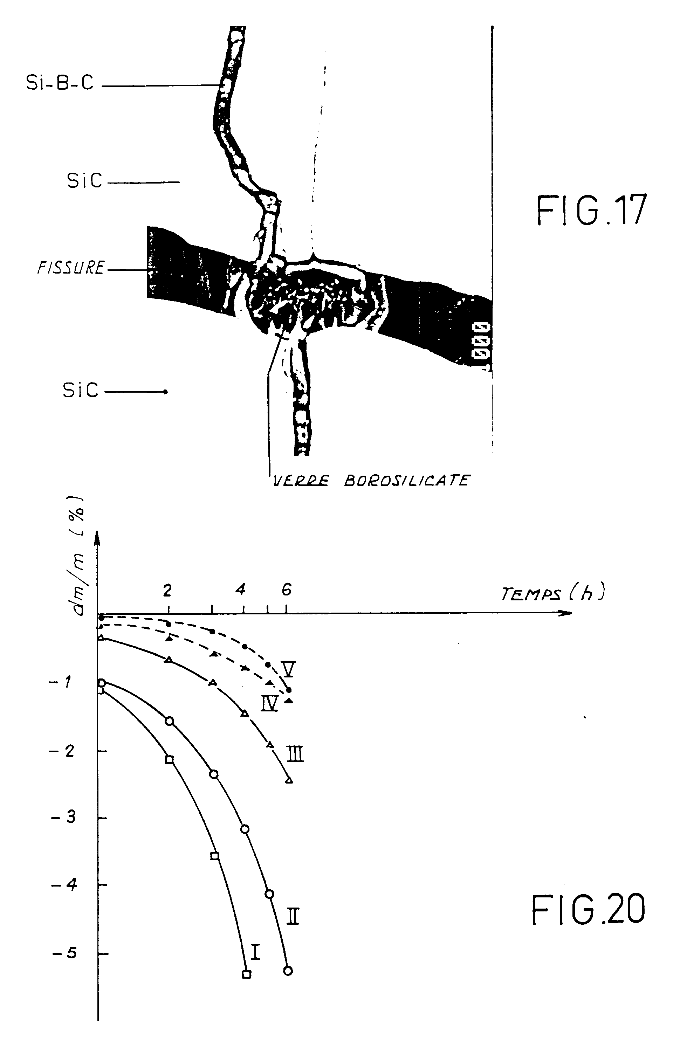

La figure 17 montre une matrice d'un matériau composite comprenant une phase Si-B-C entre deux phases SiC, avec une fissure traversant les phases SiC et Si-B-C et comblée par un verre borosilicaté.

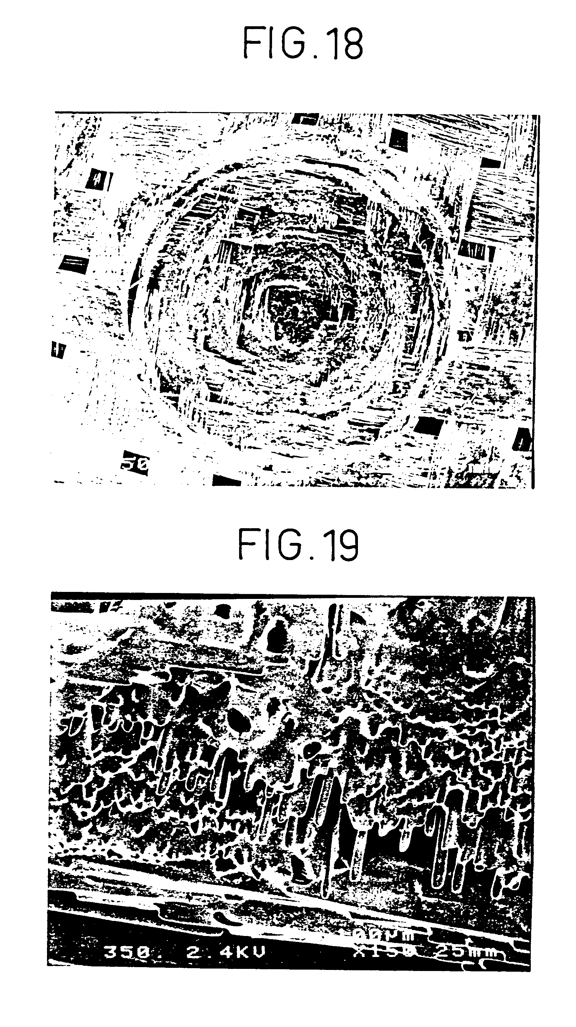

La figure 18 montre un fragment d'un matériau composite comprenant un renfort en tissu de fibres SiC et une matrice séquencée SiC et Si-B-C avec deux phases séparées Si-B-C tel qu'illustré par la figure 13. Un trou a été formé dans le matériau, mettant à nu les fibres SiC et l'interphase PyC. Après exposition à 850°C pendant 16 h, sous air, la paroi du trou a été observée. Comme cela ressort clairement de la figure 19, les extrémités des fibres rompues lors de la formation du trou sont revêtues d'une couche de verre protectrice, continue et uniforme.

L'efficacité de la protection anti-corrosion d'un matériau composite réfractaire par une phase Si-B-C sera encore montrée par les exemples ci-après.

Dans la plupart de ces exemples, la phase Si-B-C est mise en oeuvre en tant que phase externe de la matrice, éventuellement avec dépôt subséquent d'un revêtement de surface SiC. Il s'agit là simplement de montrer l'efficacité de la protection car, comme déjà indiqué, la phase Si-B-C est plutôt avantageusement intégrée à la matrice, afin notamment de ne pas risquer d'être endommagée en surface. Bien entendu, cette intégration au sein de la matrice n'a de sens que lorsque la matrice ne contient pas de carbone, au moins dans sa partie externe, comme c'est le cas des composites à matrice SiC ou à matrice C-SiC (matrice interne en carbone et externe en carbure de silicium). Dans le cas de composites à matrice carbone, tel les C/C, la phase Si-B-C est bien évidemment mise en oeuvre après la phase carbone, éventuellement avant revêtement de surface SiC.

Exemple 1

On utilise des échantillons parallélépipédiques de dimensions 20 x 10 x 2 mm en composite 2D. Ces échantillons sont obtenus par formation d'une texture fibreuse 2D en carbone (empilement de quelques strates de tissu de carbone) suivie d'infiltration chimique en phase vapeur du SiC.

Les échantillons sont munis d'un revêtement anticorrosion par dépôt chimique en phase vapeur d'un composé ternaire Si-B-C. Celui-ci est obtenu à partir d'une phase gazeuse constituée d'un mélange de MTS, $BCl_3$ et $H_2$, la température étant d'environ 1 050°C et la pression d'environ $4.10^4$ $N/m^2$. Le dépôt est poursuivi jusqu'à atteindre l'épaisseur désirée.

Trois ensembles A, B, C de pièces protégées sont réalisés avec différentes compositions de la phase gazeuse pour donner des dépôts de systèmes ternaires Si-B-C ayant les épaisseurs et les compositions (exprimées en pourcentages atomiques) suivantes :
- pour les pièces A : 35 microns d'épaisseur, Si(44 %)-B(1 %)-C(55 %)
- pour les pièces B : 35 microns d'épaisseur, Si(48 %)-B(3 %)-C(49 %),
- pour les pièces C : 40 microns d'épaisseur, Si(45 %)-B(6 %)-C(49 %).

L'efficacité de la protection anti-corrosion est vérifiée en exposant les pièces A, B, C à l'air à une température de 1 300°C pendant différentes durées et en mesurant la variation de masse relative dm/m des pièces, une perte de masse signifiant la disparition du carbone par oxydation.

Les courbes I, II et III de la figure 20 illustrent l'évolution de la perte de masse en fonction du temps, respectivement pour les pièces A, B et C. Ces courbes montrent la nécessité de former un système ternaire suffisamment riche en bore afin d'augmenter la capacité d'étanchéification du borosilicate formé en diminuant sa viscosité pour une température donnée. Une proportion de bore au moins égale à 5 % en pourcentage atomique paraît nécessaire.

Exemple 2

On utilise les mêmes échantillons de matériau composite à protéger que dans l'exemple 1.

Les échantillons sont munis d'un revêtement anticorrosion par dépôt chimique en phase vapeur, successivement, d'une couche interne SiC et d'une couche en un système ternaire Si-B-C.

La couche interne de SiC est obtenue à partir d'une phase gazeuse constituée d'un mélange de MTS et de $H_2$, la température dans la chambre de réaction étant d'environ 1 050°C et la pression d'environ $4.10^4$ $N/m^2$. Le dépôt est poursuivi jusqu'à atteindre l'épaisseur désirée.

La couche de composition ternaire Si-B-C est obtenue comme indiqué dans l'exemple 1. Le dépôt du composé ternaire Si-B-C est effectué dans la continuité du dépôt de la couche interne de SiC simplement en modifiant la composition de la phase gazeuse par adjonction de $BCl_3$, le rapport entre les débits de MTS et $BCl_3$ étant choisi en fonction de la composition voulue pour le ternaire. Le dépôt de celui-ci est poursuivi jusqu'à obtention de l'épaisseur désirée.

Un test d'oxydation sous air à 1 300°C est effectué sur des pièces D munies d'une protection anti-oxydation ainsi réalisée avec une couche interne SiC de 30 microns d'épaisseur et une couche de composition ternaire Si-B-C de 8 microns d'épaisseur et de composition Si(45 %)-B(6 %)-C(49 %), en pourcentage atomique.

L'évolution de la variation de masse dm/m est illustrée par la courbe IV de la figure 20.

Exemple 3

On procède comme dans l'exemple 2, mais en inversant l'ordre de formation des couches du revêtement de protection anti-oxydation, de sorte que l'on obtient des pièces E avec une couche de composition ternaire Si-B-C de 8 microns d'épaisseur et de composition Si(45 %)-B(6 %)-C(49 %) en pourcentage atomique, et une couche externe de SiC de 30 microns d'épaisseur.

La courbe V de la figure 20 montre l'évolution de la variation de masse dm/m des pièces E en fonction du temps au cours d'un test d'oxydation à 1 300°C.

Les courbes IV et V de la figure 20 montrent l'intérêt d'associer au moins une couche SiC avec la couche Si-B-C. Une couche interne SiC isole la couche Si-B-C du carbone sous-jacent et évite une possible réaction de celui-ci avec le bore conduisant à la formation de composés bore-carbone fragilisant le matériau. Elle empêche également une réaction à haute température entre le carbone et l'oxyde de bore formé lors de l'oxydation. Une couche externe SiC constitue une barrière supplémentaire contre l'oxydation et permet de contenir la volatilité du verre borosilicaté qui est d'autant plus importante que la teneur en bore est plus élevée. A l'évidence, ces avantages seront cumulés par la présence d'une couche interne SiC, d'une couche intermédiaire Si-B-C, et d'une couche externe SiC

## Exemple 4

On utilise des échantillons cylindriques de diamètre 25 mm et d'épaisseur 5 mm en composite 3D, échantillons obtenus par densification par infiltration chimique en phase vapeur de carbone au sein d'une texture de renfort formée de strates de tissu de carbone en forme de disques empilées et aiguilletées.

Les échantillons sont munis d'une protection anticorrosion par dépôt chimique en phase vapeur, successivement, d'une couche interne SiC, d'une couche intermédiaire Si-B-C et d'une couche externe SiC. Les couches SiC sont obtenues comme indiqué dans l'exemple 2 et la couche Si-B-C comme indiqué dans l'exemple 1. Les épaisseurs des couches de SiC interne, Si-B-C et SiC externe sont respectivement 120 microns, 50 microns et 60 microns et la composition de la phase Si-B-C, en pourcentages atomiques, est Si(30 %)-B(40 %)-C(30 %).

Après traitement d'oxydation à l'air à 1 300°C pendant 60 h puis à 1 500°C pendant 60 h, la perte de masse relative mesurée est seulement de 0,4 %.

## Exemple 5

On utilise des échantillons parallélépipédiques de dimensions 20 x 10 x 3 mm en composite C/C 3D. De façon connue en soi, ceux-ci sont formés par empilement et aiguilletage de strates rectangulaires de tissu en fibres de carbone, pour former un renfort fibreux, et densification de celui-ci par du carbone par infiltration chimique en phase vapeur.

Les échantillons sont munis d'une protection anticorrosion par dépôt chimique en phase vapeur d'une couche interne de SiC, d'une couche intermédiaire Si-B-C et d'une couche externe de SiC, comme dans l'exemple 4.

Le tableau I ci-après montre les résultats obtenus (mesure des pertes de masse relatives) pour différentes épaisseurs (en microns) des couches de protection et différents traitements d'oxydation sous air. A titre comparatif, un essai est effectué sur un échantillon muni simplement d'une couche SiC. Un essai est effectué également sur un échantillon muni simplement d'une couche Si-B-C.

TABLEAU I

| | | | | | | | |
|---|---|---|---|---|---|---|---|
| Epaisseur | | | | | | | |
| SiC interne | | 0 | 120 | 120 | 120 | 60 | 0 |
| Epaisseur | | | | | | | |
| Si–B–C | | 140 | 60 | 60 | 60 | 60 | 0 |
| Composition Si–B–C | Si | 40 | 30 | 30 | 30 | 30 | |
| (% atomique) | B | 15 | 40 | 40 | 40 | 40 | |
| | C | 45 | 30 | 30 | 30 | 30 | |
| Epaisseur | | | | | | | |
| SiC externe | | 0 | 60 | 60 | 60 | 180 | 120 |
| Conditions d'oxy- dation sous air | | $1300^{o}$C–60 h +$1500^{o}$C–60 h | $850^{o}$C 6 h | $850^{o}$C–6 h +$1000^{o}$C–6 h | $1500^{o}$C 30 h | $1500^{o}$C 30 h | $1500^{o}$C 30 h |
| Perte de masse relative (%) | | –0,9 | –0,4 | –0,6 | –0,03 | –0,1 | –9 |

On constate une efficacité de la protection conférée par la présence de la couche Si-B-C notablement supérieure à celle conférée par une couche SiC unique, et ce dans une plage de température étendue.

Exemple 6

On utilise des échantillons de matériau composite comme dans l'exemple 1.

Les tableaux II et III ci-après montrent les résultats obtenus pour différentes protections anti-corrosion comprenant une couche Si-B-C éventuellement associée à des couches de SiC interne et externe et pour différents traitements d'oxydation sous air. Dans le tableau III figurent des essais effectués, à titre comparatif, sur des échantillons non protégés. Les conditions de dépôt de SiC et de Si-B-C sont les mêmes que celles indiquées précédemment.

TABLEAU II

| | | | | | | | | |
|---|---|---|---|---|---|---|---|---|
| Epaisseur SiC interne (microns) | | 0 | 0 | 0 | 0 | 0 | 0 | 120 |
| Epaisseur Si-B-C | | 70 | 70 | 70 | 70 | 70 | 70 | 70 |
| Composition Si-B-C (pourcentages atomiques) | Si | 40 | 20 | 20 | 40 | 40 | 30 | 40 |
| | B | 20 | 40 | 40 | 20 | 20 | 40 | 20 |
| | C | 40 | 40 | 40 | 40 | 40 | 30 | 40 |
| Epaisseur SiC externe (microns) | | 0 | 0 | 30 | 30 | 0 | 30 | 30 |
| Conditions d'oxydation sous air | | 7 x 17' + 2 x 1 h 1 550°C | | id | id | id | 1 500°C 3 h | 1 500°C - 3 h +7 x 10' à 1 700°C | 1500°C 30 h |
| Variation de masse relative (%) | | -2 | -1,5 | -1 | -0,5 | -0,5 | -2 | -0,6 |

11

TABLEAU III

| | | | | | | |
|---|---|---|---|---|---|---|
| Epaisseur SiC interne (microns) | 40 | 40 | 30 | 70 | 70 | 100 |
| Epaisseur Si-B-C | 50 | 50 | 70 | 0 | 0 | 0 |
| Composition Si | 20 | 20 | 30 | | | |
| Si-B-C B | 40 | 40 | 40 | | | |
| (pourcentages atomiques) C | 40 | 40 | 30 | | | |
| Epaisseur SiC externe (microns) | 10 | 10 | 60 | 0 | 0 | 0 |
| Conditions d'oxydation sous air | 800°C 40 h | 1 500°C 24 h | 1 700°C 1 h 10' | 800°C 24 h | 1 500°C 24 h | 1 700°C 1 h 10' |
| Variation de masse relative (%) | 0 | -0,1 à -0,3 | -1,7 | -7 à -20 | -20 à -35 | -3 |

Les tableaux II et III indiquent l'excellence de la protection conférée par la présence de la couche Si-B-C et montrent que cette protection est effective dans une gamme étendue de température (voir notamment tableau III) et ce jusqu'à 1 700°C.

Exemple 7

Des échantillons de matériau composite à renfort carbone 2D sont réalisés avec une couche de protection Si-B-C intégrée au sein de la matrice SiC, comme illustré par la figure 10. A cet effet, une première phase SiC d'épaisseur égale à 1 micron est déposée sur les fibres, puis est suivie de l'infiltration d'une couche Si-B-C d'épaisseur égale à 1,5 micron, avant poursuite de la densification par infiltration de SiC, la couche Si-B-C représentant environ 30 % de la matrice.

La composition de la couche Si-B-C, en pourcentage atomique, est Si(20 %)-B(40 %)-C(40 %).

Après traitement d'oxydation sous air à 1300°C pendant 40 h, on mesure une variation de masse relative dm/m égale à +0,2 % (c'est-à-dire un léger gain de masse provenant de l'oxydation du SiC).

A titre comparatif, des échantillons de matériaux composites C/SiC 2D sont réalisés dans les mêmes conditions, à l'exception de l'intégration de la couche Si-B-C, puis sont soumis à un traitement d'oxydation sous air également à 1300°C, mais pendant 24 h seulement. Les variations de masse relatives dm/m mesurées sur différents échantillons sont comprises entre -7 à -15 %.

L'intégration de la couche Si-B-C améliore donc considérablement la tenue à l'oxydation.

Exemple 8

Des échantillons de matériau composite à renfort SiC 2D sont réalisés avec une matrice séquencée du même type que celle illustrée par la figure 13, c'est-à-dire en formant successivement une première phase Si-B-C, une phase intermédiaire SiC, une deuxième phase Si-B-C et une phase externe SiC sur des fibres SiC revêtues d'une couche de PyC et d'une couche de SiC. La matrice est constituée environ pour moitié de SiC et pour moitié de Si-B-C dont la composition, en pourcentage atomique, est Si(10 %)-B(60 %)-C(30 %).

Les échantillons sont soumis à un essai thermomécanique en flexion 4 points. L'essai en flexion 4 points consiste à placer l'échantillon entre deux points d'appui supérieurs et deux points d'appui inférieurs, disposés en quinconce. Le tableau IV ci-après donne des résultats d'essais effectués en soumettant des échantillons à des contraintes en flexion de façon permanente (fluage) pendant une même durée (100 h) et à une même température (850°C), sous air. La valeur en MPa exprime la valeur équivalente de contrainte en flexion appliquée à l'échantillon. Dans la première colonne du tableau figure la valeur de la contrainte à rupture en flexion mesurée sur un échantillon à l'état initial (sans avoir été soumis à un essai thermomécanique). A titre de comparaison figurent des résultats d'essais effectués sur des échantillons d'un autre matériau composite à renfort SiC 2D, interphase PyC et matrice SiC, sans phase Si-B-C.

## TABLEAU IV

| Matériau | Essai de rupture en flexion | Essai de fluage en flexion sous air à 850°C |
|---|---|---|
| Renfort SiC Matrice séquencée SiC + Si-B-C | rupture à 420 MPa | pas de rupture après 100 h sous 150 MPa |
| Renfort SiC Matrice séquencée SiC + Si-B-C | rupture à 420 MPa | pas de rupture après 100 h sous 180 MPa |
| Renfort SiC Matrice séquencée SiC + Si-B-C | rupture à 420 MPa | pas de rupture après 100 h sous 200 MPa |
| Renfort SiC Matrice SiC | rupture à 300 MPa | rupture après 14 h sous 150 MPa |

Le maintien du matériau composite en containte sous flexion engendrant une microfissuration importante de la matrice, le tableau IV montre l'effet protecteur apporté par la phase Si-B-C en dépit de la fissuration puisqu'à une valeur de contrainte égale à environ la moitié de la contrainte à rupture initiale en flexion une rupture n'est pas observée au bout de 100 h avec le matériau obtenu par un procédé selon l'invention, alors que la rupture se produit au bout de 14 h avec le matériau ne comprenant pas de phase Si-B-C.

**Revendications**

1. Procédé d'élaboration d'un matériau composite réfractaire protégé contre la corrosion comprenant un renfort fibreux densifié par une matrice,
caractérisé en ce que le procédé comprend la formation au sein de la matrice ou à la surface de celle-ci d'au moins une phase continue constituée par un système ternaire silicium-bore-carbone (Si-B-C) où la répartition des éléments silicium, bore et carbone est sensiblement uniforme et qui est obtenue, par infiltration chimique ou dépôt chimique en phase vapeur, à partir d'une phase gazeuse comprenant un mélange de précurseurs des éléments silicium, bore et carbone, de manière à obtenir une proportion de bore, dans le système ternaire Si-B-C, au moins égale à 5 % en pourcentage atomique.

2. Procédé selon la revendication 1, caractérisé en ce que la composition de la phase gazeuse est déterminée en fonction de la composition souhaitée du système ternaire Si-B-C pour permettre, sous atmosphère oxydante, la formation d'un verre de type borosilicate ayant, aux températures d'utilisation envisagées pour le matériau composite, les propriétés de viscosité nécessaires pour assurer une fonction cicatrisante vis-à-vis de fissures dans la matrice.

3. Procédé selon la revendication 1, caractérisé en ce qu'au moins une phase Si-B-C est formée au sein de la matrice.

4. Procédé selon la revendication 1, caractérisé en ce qu'une phase Si-B-C constitue la phase externe de la matrice.

5. Procédé selon la revendication 1, caractérisé en ce que la matrice est formée essentiellement par la phase Si-B-C.

6. Procédé selon la revendication 1 pour la protection contre la corrosion d'un matériau composite réfractaire contenant du carbone en tant qu'élément constituant le renfort fibreux ou une interphase entre le renfort fibreux et la matrice, caractérisé en ce qu'une phase réfractaire ne contenant pas de bore est formée entre ledit carbone et la phase Si-B-C.

7. Procédé selon la revendication 6, caractérisé en ce que la phase réfractaire ne contenant pas de bore est en carbure réfractaire.

8. Procédé selon la revendication 6, caractérisé en ce que la phase réfractaire ne contenant pas de bore est en carbure de silicium.

9. Procédé selon la revendication 1, caractérisé en ce qu'un revêtement en carbure ou oxyde réfractaire est forme à la surface du matériau.

10. Procédé selon la revendication 1, pour élaborer un matériau composite dans lequel la matrice comprend au moins une phase en carbure de silicium (SiC) formée par infiltration ou dépôt chimique en phase vapeur à partir d'une phase gazeuse comprenant un ou plusieurs précurseurs des éléments silicium et carbone, caractérisé en ce que la transition entre la phase SiC et une phase Si-B-C, ou inversement, est réalisée par modification progressive de la composition de la phase gazeuse par augmentation ou diminution de la proportion de précurseur de l'élément bore dans la phase gazeuse.

**Claims**

1. Method of making a refractory composite material that is protected against corrosion and that comprises a fibrous reinforcement densified by a matrix,
characterized in that the process comprises a step of forming, within the matrix or at the surface thereof, at least one continuous phase constituted by a ternary silicon-boron-carbon (Si-B-C) system in which the distribution of the silicon, boron and carbon elements is substantially uniform and which is obtained by chemical vapor deposition or chemical infiltration using a gas phase comprising a mixture of precursors for the elements silicon, boron, and carbon, in such a manner as to obtain a boron concentration in the ternary Si-B-C system that is at least equal to 5% in atomic percentage.

2. Method according to claim 1, characterized in that the composition of the gas phase is determined as a function of the desired composition of the ternary Si-B-C system so as to enable, under an oxidizing atmosphere, a borosilicate type glass to be formed which, at the intended utilization temperatures of the composite material, has appropriate viscosity properties for performing a healing function relative to cracks in the matrix.

**3.** Method according to claim 1, characterized in that at least one Si-B-C phase is formed within the matrix.

**4.** Method according to claim 1, characterized in that one Si-B-C phase constitutes the outer phase of the matrix.

**5.** Method according to claim 1, characterized in that the matrix is essentially formed by the Si-B-C phase.

**6.** Method according to claim 1 for protecting from corrosion a refractory composite material containing elemental carbon constituting the fibrous reinforcement or an interphase between the fibrous reinforcement and the matrix, characterized in that a refractory phase that does not contain boron is formed between said carbon and the Si-B-C phase.

**7.** Method according to claim 6, characterized in that the refractory phase that does not contain boron is a refractory carbide.

**8.** Method according to claim 6, characterized in that the refractory phase that does not contain boron is a silicon carbide.

**9.** Method according to claim 1, characterized in that a surface coating of a refractory oxide or carbide is formed at the surface of the material.

**10.** Method according to claim 1, for making a composite material in which the matrix comprises at least one silicon carbide (SiC) phase formed by chemical vapor deposition or infiltration from a gas phase comprising one or more precursors of the elements silicon and carbon, characterized in that the transition between the SiC phase and an Si-B-C phase, or *vice versa*, occurs by smoothly changing the composition of the gas phase by increasing or reducing the content of the precursor for the element boron in the gas phase.

**Patentansprüche**

**1.** Verfahren zur Herstellung eines hitzebeständigen Verbundmaterials, das gegen Korrosion geschützt ist und eine matrixverdichtete faserige Verstärkung aufweist,
**dadurch gekennzeichnet, daß**
das Verfahren innerhalb der Matrix oder an deren Oberfläche die Bildung wenigstens einer kontinuierlichen Phase umfaßt, die aus einem ternären Silicium-Bor-Kohlenstoff-System (Si-b-B), in dem die Verteilung der Silicium-, Bor- und Kohlenstoffelemente im wesentlichen gleichmäßig ist und die durch chemische Infiltration oder chemische Ablagerung in der Dampfphase ausgehend von einer Gasphase erhalten wird, die ein Gemisch von Vorläufern von Silicium-, Bor- und Kohlenstoffelementen umfaßt, um eine Verteilung von Bor im ternären Si-B-C-System von wenigstens 5 Atom-% zu erhalten.

**2.** Verfahren nach Anspruch 1,
**dadurch gekennzeichnet, daß**
die Zusammensetzung der Gasphase in Abhängigkeit von der Soll-Zusammensetzung des ternären Si-B-C-Systems bestimmt wird, um in Sauerstoffatmosphäre die Bildung eines Borsilicatglases zu ermöglichen, das bei den beabsichtigten Verwendungstemperaturen für das Verbundmaterial die notwendigen Viskositätseigenschaften hat, um eine gegenüber Rissen in der Matrix heilende Funktion sicherzustellen.

**3.** Verfahren nach Anspruch 1,
**dadurch gekennzeichnet, daß**
wenigstens eine Si-B-C-Phase innerhalb der Matrix gebildet wird.

**4.** Verfahren nach Anspruch 1,
**dadurch gekennzeichnet, daß**
eine Si-B-C-Phase die äußere Phase der Matrix bildet.

**5.** Verfahren nach Anspruch 1,
**dadurch gekennzeichnet, daß**
die Matrix im wesentlichen durch die Si-B-C-Phase gebildet wird.

**6.** Verfahren nach Anspruch 1 zum Schutz eines hitzebeständigen Verbundmaterials gegen Korrosion, das Kohlenstoff als Element enthält, das die faserige Verstärkung bildet, oder eine Zwischenphase zwischen der faserigen Verstärkung und der Matrix,
**dadurch gekennzeichnet, daß**
eine hitzebeständige Phase, die kein Bor enthält, zwischen dem Kohlenstoff und der Si-B-C-Phase gebildet wird.

**7.** Verfahren nach Anspruch 6,
**dadurch gekennzeichnet, daß**
die hitzebeständige Phase, die kein Bor enthält, aus hitzebeständigem Carbid besteht.

**8.** Verfahren nach Anspruch 6,
**dadurch gekennzeichnet, daß**
die hitzebeständige Phase, die kein Bor enthält, aus Siliciumcarbid besteht.

**9.** Verfahren nach Anspruch 1,
**dadurch gekennzeichnet, daß**
ein hitzebeständiger Carbid- oder Oxidüberzug auf der Oberfläche des Materials gebildet wird.

**10.** Verfahren nach Anspruch 1 zur Herstellung eines Verbundmaterials, bei dem die Matrix wenigstens eine Siliciumcarbid-Phase (Sic) umfaßt, die durch Infiltration oder chemische Ablagerung in der Dampfphase ausgehend von einer gasförmigen Phase gebildet wird, die einen oder mehrere Vorläufer von Silicium- und Kohlenstoffelementen enthält,
**dadurch gekennzeichnet, daß**
der Übergang zwischen der SiC-Phase und einer Si-B-C-Phase durch fortschreitende Modifizierung der Zusammensetzung der gasförmigen Phase durch Erhöhung oder Verringerung des Anteils des Vorläufers des Borelementes in der gasförmigen Phase hergestellt wird.

FIG.1

AGENTS CORROSIFS

FIG.2

FIG.3

FIG.4

$B_4C$    $S_iC$

$B_2O_3$    $S_iO_2$

FIG.5

$B_4C$    $S_iC$

$B_2O_3$    $S_iO_2$

FIG.6

$B_4C$    $S_iC$

$B_2O_3$    $S_iO_2$

FIG.7

# FIG.8

# FIG.9

EP 0 483 009 B1

FIG.10

FIBRE C
MATRICE SiC
PHASE Si-B-C
MATRICE SiC

FIG.11

MATRICE SiC

PHASE Si-B-C

FIBRE SiC     INTERPHASE PyC

21

FIG.12

Analyses élémentaires par MICROSONDE DE CASTAING

# FIG.13

M  I  F       Si_B_C

FIG.14

V(SiO$_2$, B$_2$O$_3$)

FIG.15

M  I  F

V(SiO$_2$, B$_2$O$_3$)

M  I  F

FIG.16

V(SiO$_2$, B$_2$O$_3$)

Si-B-C

SiC

FISSURE

SiC

VERRE BOROSILICATE

FIG.17

dm/m (%)

TEMPS (h)

V

IV

III

II

I

FIG.20

## FIG.18

## FIG.19